# EUROPÄISCHE PATENTSCHRIFT

(11) **EP 1 365 478 B1**
(45) Veröffentlichungstag und Bekanntmachung des Hinweises auf die Patenterteilung: **29.12.2004**
(21) Anmeldenummer: 03010345.1
(22) Anmeldetag: 08.05.2003
(51) Int. Cl.: H01R 9/26

(54) **Modulreihung und Adaptermodul**
Module aligned and adapter module
Module aligné et module adaptateur

(30) Priorität: 21.05.2002 DE 20208041 U
(43) Veröffentlichungstag der Anmeldung: 26.11.2003
(73) Patentinhaber: Weidmüller Interface GmbH & Co., 32760 Detmold (DE)
(72) Erfinder: Höing, Michael, 32657 Lemgo (DE); Schnatwinkel, Michael, 32051 Herford (DE); Hanning, Walter, 32758 Detmold (DE)
(74) Vertreter: Dantz, Jan Henning

(56) Entgegenhaltungen:
- EP-A- 0 661 915
- US-A- 4 956 747
- US-A- 5 716 241

## Beschreibung

Die Erfindung betrifft eine Modulreihung aus Modulen, insbesondere der Automatisierungstechnik.

Aus der DE 199 20 745 ist ein elektrisches Gerät bekannt, welches einen modularen Aufbau aufweist und zur Steuerung und/oder Überwachung technischer Prozesse und/oder zur Industrie- oder Gebäude- oder Prozeßautomatisierung dient.

Dieses elektrische Gerät umfaßt Anschlußstationen (dort als Module bezeichnet, wogegen in der vorliegenden Anmeldung mit einem Modul die einzelne Scheibe oder der einzelne Block bezeichnet wird) mit mehreren Ebenen von Anschlüssen zum Anschluß externer Leiter und mit einer Aneinanderreihung aus scheiben- oder blockartigen Basisklemmenträgem. Innerhalb dieser Anschlußstationen sind im wesentlichen parallel zur Tragschiene ein interner Busleiter sowie mehrere Potentialführungen ausgebildet.

Ein anderes elektrisches Gerät dieser Art zeigt die EP 95 113 730 A1, wobei hier auf Tragschienen anreihbare Anschlußblocks zur Signalanpassung zwischen einem übergeordneten Feldbus und an die Anschlußblocks angeschlossene Initiatoren, Feldgeräten o.dgl. dienen. Die Anschlußblocks sind wiederum aus funktionsverschiedenen Anschlüssen bzw. Modulscheiben zusammengesetzt. Einer oder mehrere Anschlußblocks sind über den internen Busleiter mit einem Anschlußmodul für einen Feldbus verbunden.

Weitere elektrische Geräte mit einer modularen Bauart sind von anderen Herstellern bekannt.

Der Anwender hat bisher im Grunde keine Möglichkeit dazu, bei der Realisierung einer auf seine Applikation zugeschnittenen Station auch Module verschiedener Hersteller oder verschiedener Bauart (d.h. nicht zwei an sich baugleiche Module einer Bauart und Größe und nur unterschiedlichen Kontakten im gleichen Raster, wie in der US 5,716241 die als nächstliegender Stand der Technik angesehen wird beschrieben, sondern grundsätzlich unterschiedlich aufgebaute, nicht kompatible Module verschiedener Bauart) miteinander zu kombinieren, obwohl dies beispielsweise zur Senkung der Beschaffungskosten oder zur Steigerung des Nutzens durch sonst nicht realisierbare Funktionen - z.B. steckbare Elektroniken, stehende Verdrahtungen oder keine Steckanschlüsse für Sensoren/Aktoren sondern nur fest integrierte Anschlüsse - durchaus gewünscht ist.

So gibt es Systeme, welche keine Lösungen für Digitalfunktionen aufweisen oder keinen Block- sondern nur einen scheibenartigen Aufbau. Es ist daher wünschenswert, verschiedene Systeme miteinander zu kombinieren. Es gibt eine ganze Reihe weiterer ähnlicher Probleme, so beispielsweise das Problem, daß innerhalb eines Systems keine zugeschnittene Anschlußanzahl für die häufigsten Feldgeräte existieren oder daß beispielsweise das Problem gegeben ist, daß bei einem System beim Fehlen oder Ziehen eines Moduls die Station ausfällt, während andere Systeme derart ausgebildet sind, daß solche Fehler sicher abgefangen werden.

Es besteht daher der Bedarf, die verschiedenen Systeme miteinander kombinieren zu können, um so dem Kunden und Anwender die Möglichkeit zu verschaffen, durch eine Auswahl der besten bzw. geeignetsten Module verschiedener Bauart seine individuelle Station zusammenzustellen.

Die Lösung dieses Problems ist die Aufgabe der Erfindung.

Die Erfindung löst diese Aufgabe durch den Gegenstand des Anspruches 1.

Durch diese einfache Maßnahme wird es möglich, das gestellte Problem umfassend zu lösen. Es muß lediglich beim Aneinanderreihen der Module zur Realisierung der Station zwischen die Module der verschiedenen Bauarten das Adaptermodul gesetzt werden.

Die Module können auf der Tragschiene axial aneinanderreihbar sein oder sie werden senkrecht zur Tragschiene z.B. an Nuten oder dergleichen zusammengeschoben

Mit der Erfindung ist es insbesondere möglich, Kontakte miteinander zu verbinden, welche bei den Modulen verschiedener Bauart eine verschiedene Höhenlage zur Tragschiene, eine verschiedene Tiefenlage in Relation zur Tragschienenmitte, ein unterschiedliches Raster, unterschiedliche Kontakt- oder Verbindungssysteme und unterschiedliche Anzahlen von Kontakten aufweisen. Dabei wird bevorzugt eine serielle Stromführung verwendet, wobei das Adaptermodul vorzugsweise für Bus- und Ringstrukturen geeignet ist. Insbesondere können auch verschiedene mechanische Modulaufbauten auf diese Weise unkompliziert miteinander verbunden werden.

Für den Automatisierungshersteller bietet sich hier der besondere Vorteil, daß er alle für seine Marktsegmente wichtigen und möglichen Nutzenpakete von elektromechanischen Gehäusekonzepten möglichst kostengünstig und umfassend seinen Kunden anbieten kann, ohne daß er zuviel Investitionen in Werkzeuge für verschiedene elektromechanische Gehäusekonzepte tätigen muß (falls auf diese über Lieferanten zurückgreifen kann).

Vorteilhafte Ausgestaltungen der Erfindung sind den Unteransprüchen zu entnehmen.

Neben den in den Unteransprüchen genannten Ausführungsbeispielen sind auch noch folgende Ausführungsbeispiele und/oder Vorteile zu erwähnen.

Vorzugsweise sind die Kontakte auf den beiden Axialseiten des Koppelmoduls über wenigstens eine oder mehrere Leiterplatte(n) einfach und kostengünstig miteinander verbunden. Alternativ/Optional können die Kontakte auf den beiden Axialseiten des Koppelmoduls über wenigstens ein Kabel, insbesondere eine Flachbandverbindung und/ oder Folienleiter miteinander verbunden werden.

Eine aufrecht stehende Leiterplatte kann Verbindungselemente oder Teile davon in den beiden unterschiedlichen Anreihrichtungen aufnehmen. Diese Lösung baut sehr kompakt. Alternativ ist auch eine waagerecht liegende Leiterplatte realisierbar.

Ein Lagenversatz interner Modulbusse kann problemlos durch Lagenversatz der linken und rechten Verbindungselemente bzw. Kontakte ausgeglichen werden. Ebenfalls ist es möglich, bei potentieller Kontakt- oder Lötstiftkollision der linken und rechten Verbindungselemente diese durch eine oder eine zweite Leiterplatte zu verhindern.

Die zweite Leiterplatte kann beispielsweise über eine Starrflex-Verbindung einstückig mit der ersten Leiterplatte verbunden sein oder aber es wird eine Verbindung über einen weiteren Steckverbinder realisiert. Die Starrflex-Platte kann im eingebauten Zustand ein U-Profil ausbilden. Mögliche durchkontaktierte Lötstifte von Kontakten zwischen den Leiterplatten könnten durch eine Folie einfach isoliert werden.

Es ist ferner denkbar, daß die beiden starren Leiterplattenenden links und rechts in zwei unterschiedlichen Positionen fixiert werden, um zwei verschiedene Bauarten nicht sortenrein auf der Tragschiene positionieren zu müssen.

Darüber hinaus können die Daten- und Versorgungsleitungen der unterschiedlichen mechanischen Modulbusse parallel/1:1/zugehörig lagenversetzt und über Leiterbahnen miteinander verbunden werden. Dies ist problemlos auf der Leiterplatte realisierbar, welche dann eine entsprechende Leiterbahnbestückung bzw. -bedruckung aufweist.

Nicht benötigte Daten- oder Versorgungsleitungen, die also nicht von Modul zu Modul weitergegeben werden müssen, können in geeigneter Weise auf Masse gelegt bzw. als Masse genutzt werden.

Bei integrierter I/O-Elektronik in dem Modulgehäuse ist es auch denkbar, innerhalb des Adaptermodulgehäuses beliebige weitere Querverbinder oder Kontakte der beiden Module leitend miteinander zu verbinden, so beispielsweise FE-Kontakte, Minus-, Plus- oder PE-Querverbinder, die auf beliebige Art, beispielsweise über Leiterbahnen auf der Leiterplatte oder über Stifte o.dgl. von einer Kontaktseite zur anderen geführt werden.

Dabei könnte die Minus-, Plus- und PE-Querverbindung auch direkt unter der Anschlußebene liegen. In der Anschlußebene des Adaptermoduls sind über den Querverbindern rechteckige Sensor-/Aktorstecker realisierbar, so daß auch das Adaptermodul selbst in vorteilhafter Weise zum Anschluß dieser Geräte nutzbar wird.

Die Kontakte des abgewandelten Sensor-Aktor-Steckers selbst können als platzsparende Crimpkontakte oder IDC-Kontakte ausgebildet werden. Dabei könnten die Stekker einstückig in 2-, 3-, 4-Leitertechnik oder 1-polig zu derselben verknüpfbar ausgebildet werden. Bei IDC-Kontakten wäre auch ein gleichzeitiges Anschlagen aller Leiter pro Sensor/Aktor realisierbar.

Durch Elemente wie Vorsprünge, Rücksprünge, Schlitze und Haken oder Hinterschnitte ist es ferner möglich, das Adaptermodul an seinen beiden Seiten jeweils mit den anzureihenden Modulen auch mechanisch zu koppeln.

Es ist auch denkbar, die aneinandergeschobenen Module von oben her über einen Zusatzteil zu verstocken. Es ist ferner denkbar, das Zwischenstück quasi nur als Trägerelement auszubilden und diesem kein eigenes Gehäuse zuzuordnen. Denkbar ist es, im Adaptergehäuse auch Schubladen zur Aufnahme von Ersatzteilen, wie Sicherungen o.dgl. vorzusehen.

Realisierbar ist prinzipiell auch ein Aufbau des Adaptermoduls mit Klemmenträgern, welche aus einer Schale, einer Seitenwand und ggf. einem transparenten Deckel bestehen.

Dabei ist es prinzipiell vorteilhaft, Klemmenträger und/oder das Gehäuse des Klemmenträgers für das Adaptermodul nach Art von einem der beiden miteinander zu verbinden Module auszubilden, wobei der innere Aufbau des Adaptermoduls dann aber nicht unbedingt dem inneren Aufbau von einem der beiden Module entspricht.

Denkbar ist es ferner, in das Adaptermodul auch elektronische Funktionen - z.B. eine Elektronikschaltung - zu integrieren.

Die Leiterplatte wird dabei vorteilhaft mit einer I/O-Elektronik mit Busanschaltung und Verbindungselementen für den Modulbus bestückt. Derart realisierbar sind beispielsweise Bus- und Ringstrukturen mit 1:1-Weiterleitungen bzw. -Übersetzungen, aber auch versetzte Datenleitungen.

Nachfolgend wird die Erfindung anhand von Ausführungsbeispielen näher beschrieben. Es zeigt:
- Figur 1: einen Schnitt durch ein erstes Ausführungsbeispiel einer erfindungsgemäßen Modulreihung;
- Figur 2: eine perspektivische Ansicht der Modulreihung aus Figur 1;
- Figur 3 und 4: einen Schnitt und eine perspektivische Ansicht eines zweiten Ausführungsbeispiels der Erfindung;
- Figur 5 und 6: einen Schnitt und eine perspektivische Ansicht eines dritten Ausführungsbeispiels der Erfindung;
- Figur 7 und 8: einen Schnitt und eine perspektivische Ansicht eines vierten Ausführungsbeispiels der Erfindung;
- Figur 9 und 10: perspektivische Ansichten einer aus einer erfindungsgemäßen Modulreihung gebildeten Station;
- Fig. 11 und 12: zwei verschiedene Module in verschiedenen Ansichten.

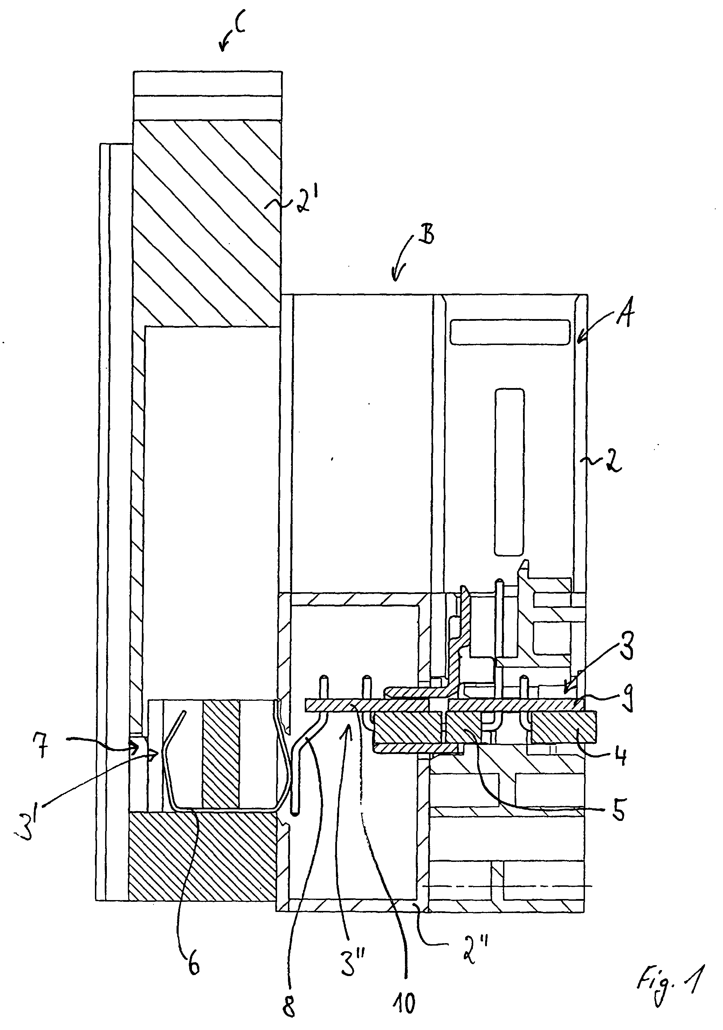

Fig. 1 zeigt ein Aneinanderreihung von drei Modulen A, B und C auf einer hier (nicht abgebildeten) Tragschiene.

Es kann sich dabei beispielsweise um Module der Automatisierungstechnik handeln oder um Reihenklemmen sonstiger Art, welche Querverbinder an ihren Axialseiten aufweisen, die zur Querverbindung von Potentialen über mehrere aneinander gereihte Reihenklemmen hinweg dienen.

Dabei sind die Module A und C in verschiedener Bauart ausgestaltet und weisen an ihren aneinanderreihbaren Axialseiten jeweils mehrere Kontakte auf.

Das in Fig. 1 rechte Modul A einer ersten Bauart ist auf eine Tragschiene aufrastbar und weitgehend nach Art der DE 19920745 konzipiert. Es weist einen Klemmenträger 2 (und ggf. ein Gehäuse) sowie einen internen, im Klemmenträger 2 angeordneten mehrpoligen internen Busleiterabschnitt 3 auf, der querverbinderartig von Modul zu Modul weitergeleitet wird, so daß ein sich über die Aneinanderreihung aus den Modulen erstreckender übergreifender interner Busleiter gebildet wird.

Dazu weist der interne Busleiterabschnitt 3 eine parallel zur Tragschiene ausgerichtete bzw. senkrecht zur Haupterstreckungsebene des Moduls ausgerichtete Leiterplatte 9 auf, an deren Unterseite zu den Stirn- bzw. Axialseiten (relativ zur Tragschiene) der Klemmenträger 2 eine Buchsenleiste 4 und eine Steckerleiste 5 angesetzt sind. Beim Aneinanderreihen der Module A auf einer Tragschiene greift jeweils die Steckerleiste 5 eines Moduls mit ihren Kontakten (hier rechts) in die Buchsenleiste 4 des jeweils vorhergehenden Moduls ein.

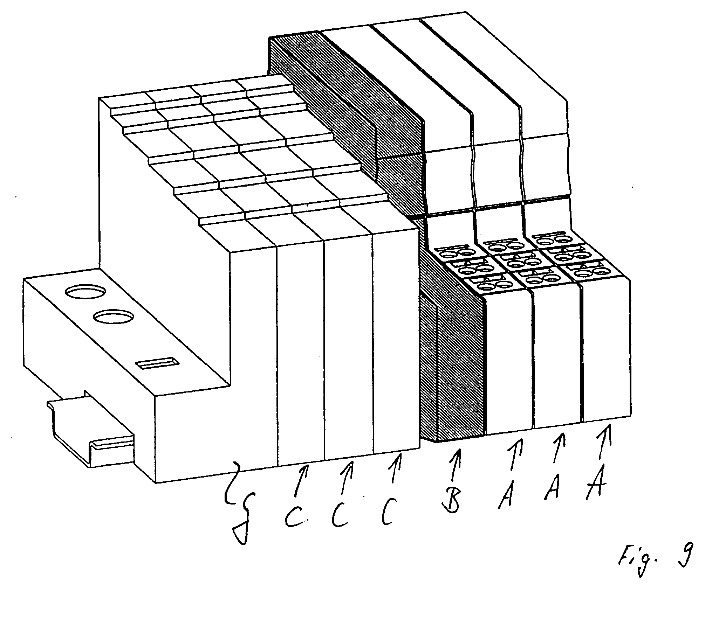

Das in Fig. 1 linke, ebenfalls reihenklemmenartig ausgebildetes Modul C der zweiten Bauart weist einen in diesem Schnitt etwas größeren Klemmenträger 2' als das Modul A auf. Der hier gezeigte Teil eines internen Busleiterabschnitts 3' weist gebogene Stiftkontakte 6 auf, die auf einer der Axialseiten (bzw. den Anreihflächen) des linken Moduls C über dessen Seitenfläche nach außen hin vorstehen, so daß sie in eine Ausnehmung 7 des Klemmenträgers des nächsten anzureihenden Moduls C (siehe Fig. 9) dieser Bauart eingreifen können.

Auf diese Weise können mehrere Module vom Typ "A" oder "C" aneinandergereiht werden (siehe auch Fig. 9), wobei die Verbindung der internen Busleiterabschnitte 3 der einzelnen Module einfach beim Aneinanderrasten der Module hergestellt wird. Dagegen sind die Module A und C nicht kompatibel, d.h., die Busleiterabschnitte 3, 3" dieser beiden Modultypen (und ggf. weitere Querverbindungen) kontaktieren einander beim Aneinanderreihen auf der Tragschiene nicht oder nur zufällig teilweise.

Die Erfindung setzt vor diesem Hintergrund bei der Idee an, zwischen Modulen verschiedener Bauart (z.B. verschiedener Hersteller) auch innerhalb einer Applikation wechseln zu können.

So soll es nach der Erfindung möglich sein, an ein Gateway G oder eine sonstige Kopfstation (Fig. 9) einer Bauart zunächst Module des gleichen Typs anzureihen und dann die Bauart zu wechseln, beispielsweise, um Modulscheiben einer bestimmten Art eines anderen Herstellers einzusetzen, welche innerhalb der sonst verwendeten Bauart nicht angeboten werden.

Die Erfindung schafft auf einfache konstruktive Weise eine Möglichkeit zur Lösung dieser Problematik.

Die in Fig. 1 mittlere Klemme, das Adaptermodul B, realisiert eine leitende Verbindung zwischen den Kontakten des internen Busleiters des linken Moduls C und des rechten Moduls A, so daß es möglich ist, auf der Tragschiene ein elektrisches Gerät des Automatisierungstechnik zusammenzustellen, welches aus Modulen verschiedener Bauart besteht.

So können auch axialseitige, zur Querverbindung vorgesehene Kontakte von Modulen verschiedener Bauart und/oder verschiedener Anordnung miteinander verbunden werden, indem ein gegebener Höhenversatz, ein Seitenversatz und/oder unterschiedliche Raster der Kontakte am Klemmenträger ausgeglichen wird.

Diese Situation zeigt Fig. 9, in welcher an ein Gateway G Module zunächst drei Module der Bauart C angereiht sind. An diese drei Module C bzw. Modulscheiben schließt sich das Adaptermodul B an, an dessen vom Modul C abgewandte Axialseite wiederum drei Module der Bauart A angereiht sind. Es ist somit problemlos möglich, z.B. auch Module (Scheiben oder Blöcke) verschiedener Hersteller miteinander zu kombinieren. Dabei können entweder nur die Kontakte der internen Busleiterabschnitte 3, 3', 3" querverbinderartig miteinander verbunden werden oder es können auch weitere Potentiale (z.B. Masse, + oder -) zur Versorgung von Sensoren oder dergleichen, welche an die Module anschließbar sind, über das Adaptermodul B querverbunden werden. Alternativ zu elektrischen Verbindungen wären Lichtleiterverbindungen (z.B. aus Lichtleitstiften) realisierbar.

Dabei ist auch im Modul B mit dem Klemmenträger 2", dessen Axialseite hier im wesentlichen der der Module A entspricht, ein interner Busleiterabschnitt 3" ausgebildet, der zum rechten Modul A hin Kontakte aufweist, welche mit den Kontakten der internen Busleiters 3 - also der Stiftleiste 5 - des rechten Moduls A der ersten Bauart und mit den Kontakten - Druck- und Stiftkontakte 6 - der internen Busleiter 3 des linken Moduls der ersten Bauart kompatibel bzw. zusammenfügbar sind.

Im vorliegenden Fall weist der interne Busleiterabschnitt 3" des Koppelmoduls B zur rechten Seite eine Buchsenleiste 4 auf, welche zur Aufnahme der Steckerkontakte der Steckerleiste 5 des benachbarten Moduls B ausgerichtet sind. Der interne Busleiterabschnitt 3" des Koppelmoduls B weist ferner zur linken Seite hin einfach gebogene Stiftkontakte 8 auf, welche zur Kontaktierung der Druckkontakte 6 des linken Moduls C ausgebildet sind. Die Buchsenleiste 4 und die Stiftkontakte 8 sind leitend miteinander verbunden, hier durch eine Leiterplatte 10, die parallel zur Tragschiene ausgerichtet ist.

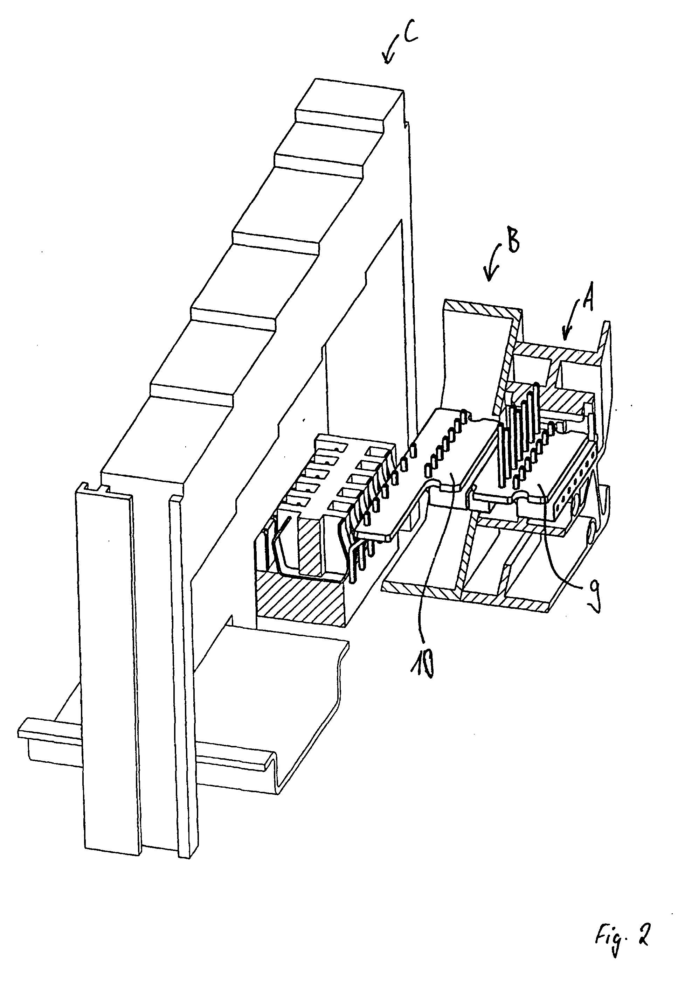

Eine Sprengansicht diese Bauvariante zeigt Fig. 2.

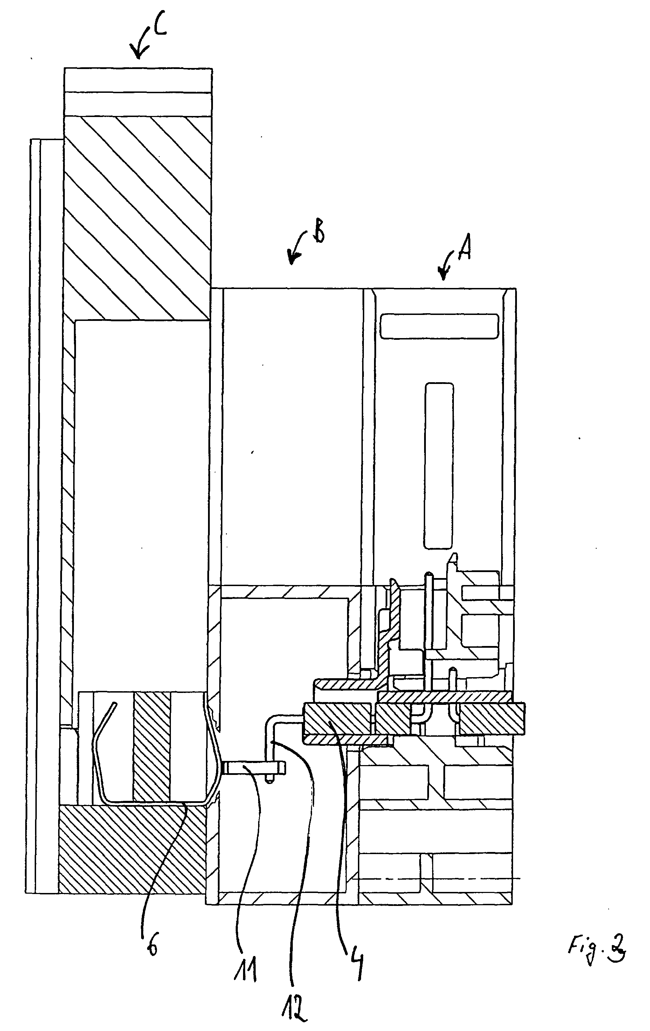

Das Ausführungsbeispiel der Fig. 3 entspricht weitgehend dem der Fig. 1. Anstelle der Stiftkontakte 8 aus Fig. 1 dient hier aber eine besonders kostengünstige Leiterplatte 11 mit Kontaktrand (z.B. aus Gold) direkt zur Kontaktierung der Druckkontakte 6. Die Buchsenleiste 4 und die Leiterplatte 11 sind mittels in sich gebogenen weiteren Stiften 12 leitend miteinander verbunden.

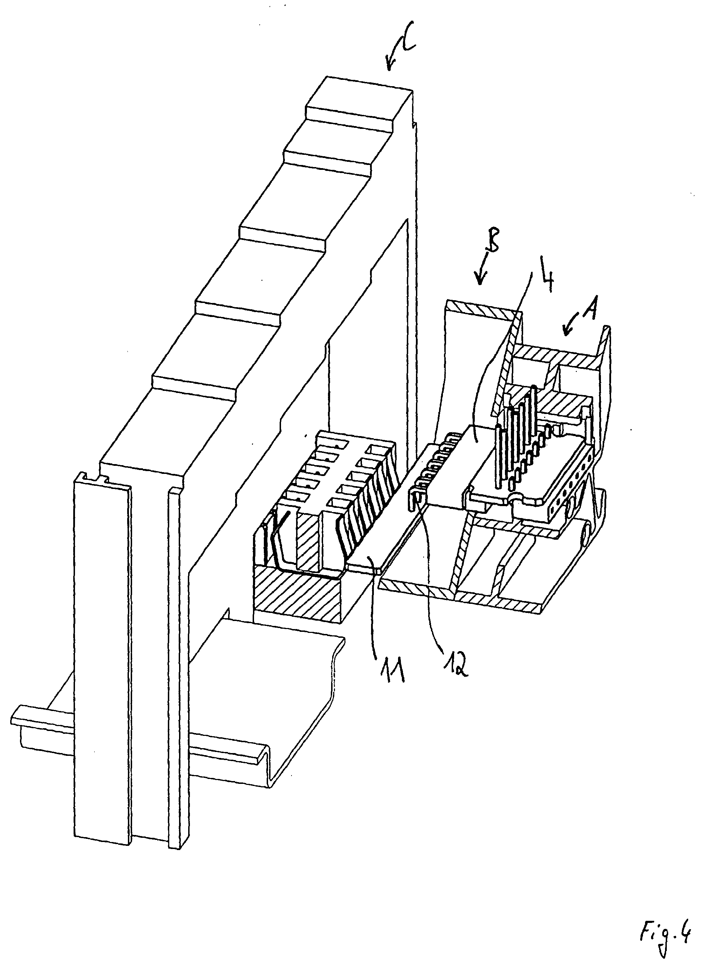

Eine perspektivische Ansicht dieser Bauvariante zeigt Fig. 4.

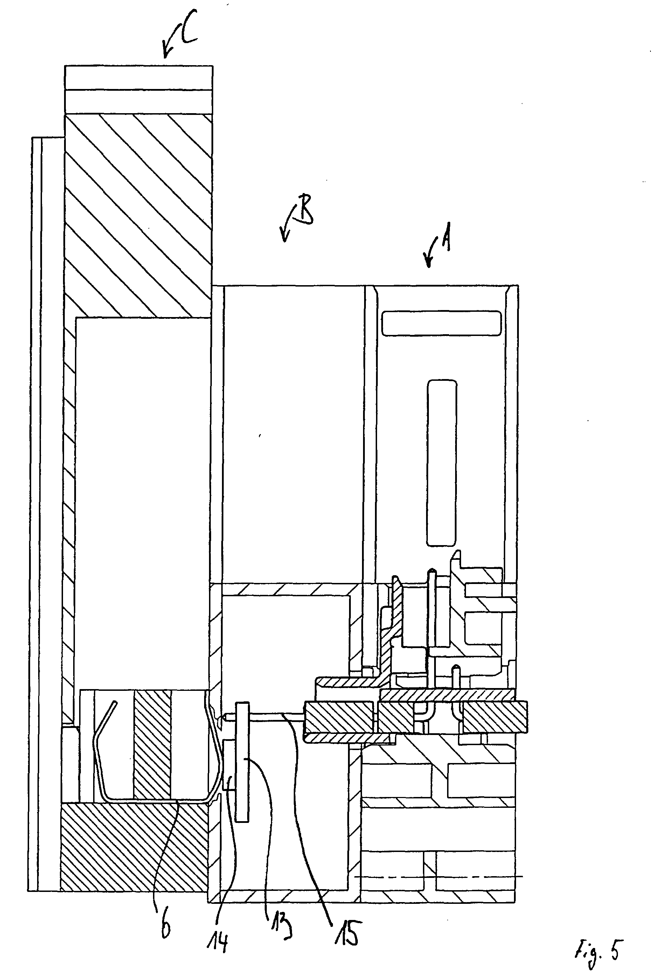

Eine ähnliche Variante zeigt Fig. 5. Anstelle der Stiftkontakte 8 aus Fig. 1 dient auch hier eine kostengünstige, senkrecht zur Tragschiene ausgerichtete Leiterplatte 13 mit Kontaktbereichen 14 (z.B. aus Gold) direkt zur Kontaktierung der Druckkontakte 6 des Moduls "C". Die Ankopplung an das rechte Modul A erfolgt wiederum mit einer Buchsenleiste 4. Die Buchsenleiste 4 und die Leiterplatte 13 des Adaptermoduls B sind mittels Stiften 15 leitend miteinander verbunden.

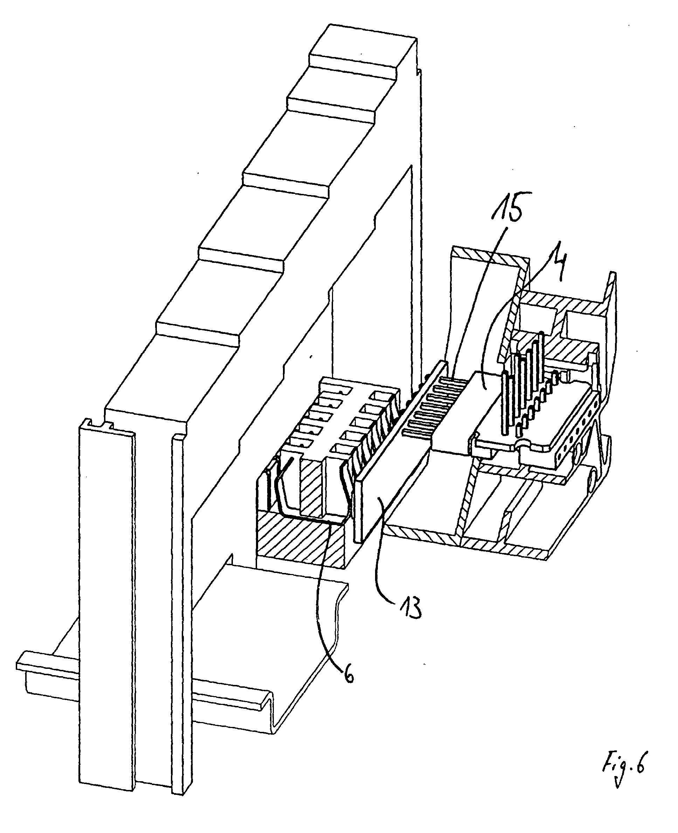

Eine perspektivische Ansicht dieser Bauvariante zeigt Fig. 6.

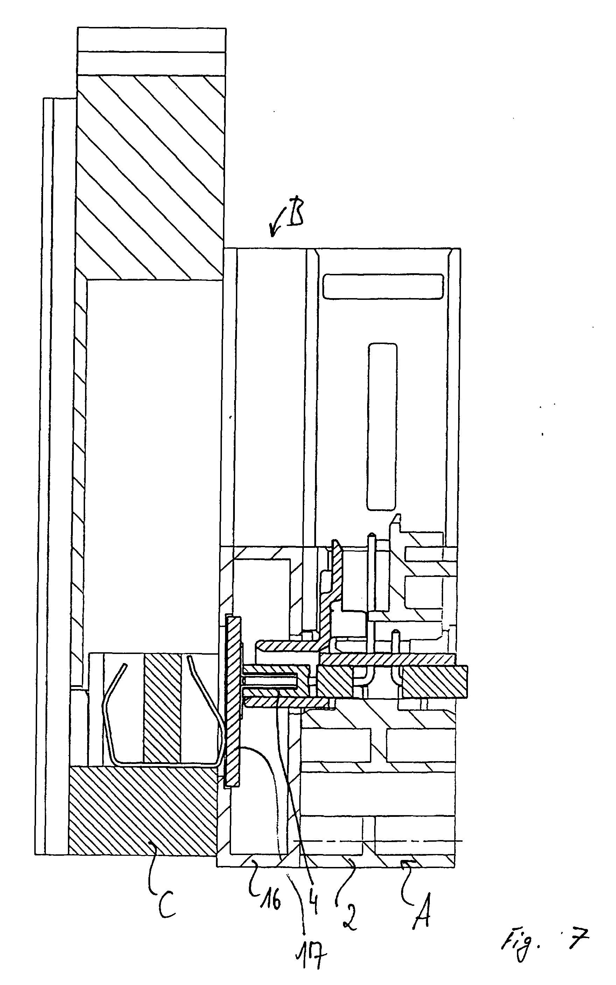

Nach der Variante der Fig. 7 ist das Adaptermodul als Zwischenklemmenträger 16 ausgebildet, der im Gegensatz zu Fig. 1 bis 6 nicht unbedingt auch selbst auf eine Tragschiene aufrastbar ist sondern direkt zwischen die miteinander zu verbindenden Module A und C gesetzt, z.B. geklemmt wird. Dabei ist eine Buchsenleiste 4 direkt auf eine senkrecht zur Tragschiene ausgerichtete Leiterplatte 17 aufgesetzt, um die Umsetzung von einer Kontaktart zur anderen zu gewährleisten. Um die Baubreite des Adpatermoduls weiter zu verringern, kann die Buchsenleiste 4 auch durch eine Öffnung der Leiterplatte hindurch geschoben und dort verlötet werden (nicht dargestellt).

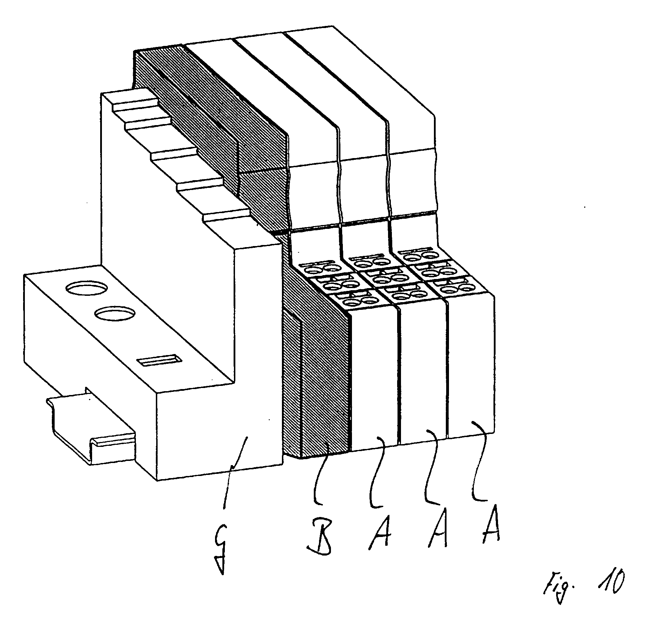

Derart verbindbar sind Modulscheiben und/oder blöcke verschiedensten Typs (Fig. 9), wobei hier das Gateway ebenfalls als Modul betrachtet wird, d.h., das Adaptermodul B kann auch direkt an ein Gateway G angereiht werden (Fig. 10), um direkt hinter dem Gateway zu Modulen anderer Bauart überzugehen.

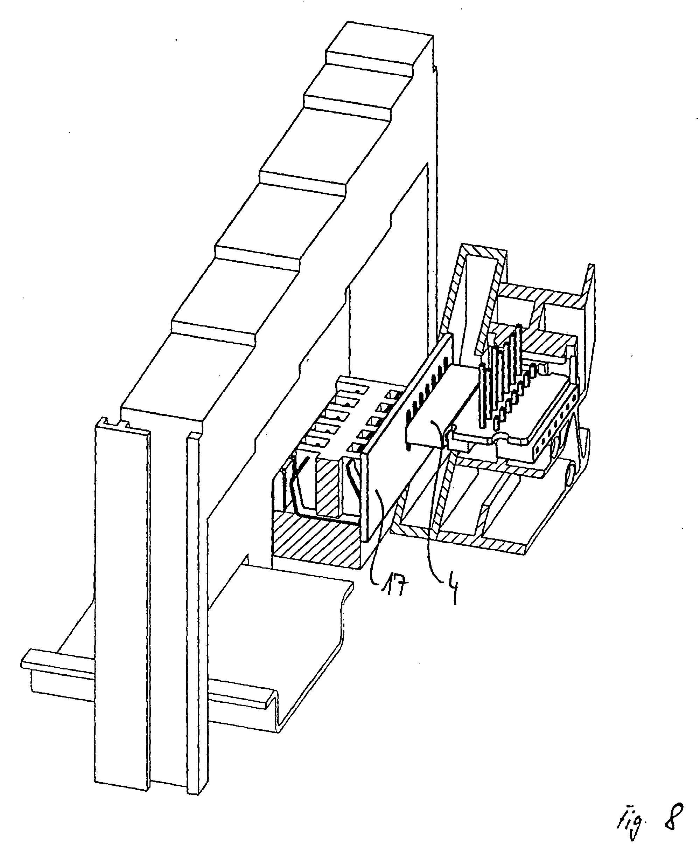

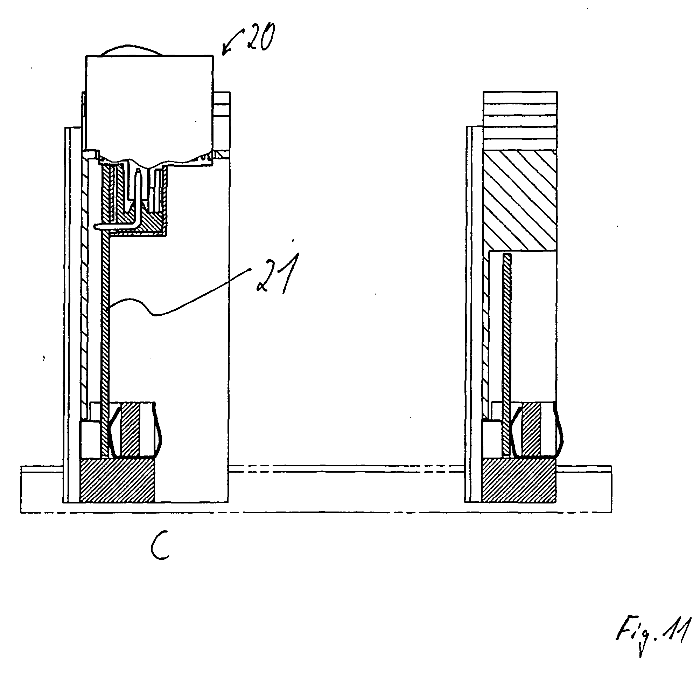

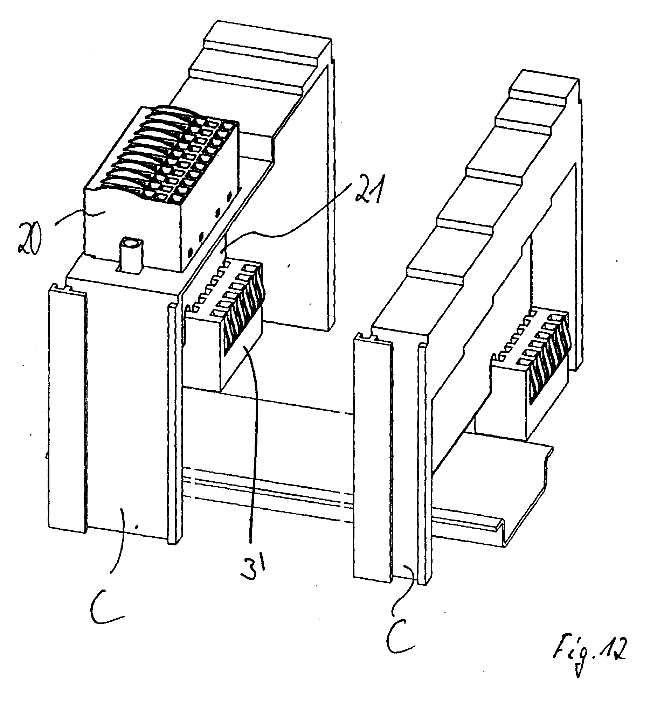

Fig. 11 und 12 zeigen zwei Module des Typs C. Das rechte Modul C entspricht den Modulen C der Fig. 1 bis 10. Das linke Modul C weist dagegen an seiner von der Tragschiene abgewandten Oberseite einen kompakt bauenden Anschlussstecker als Anschlussebene für Sensoren, Aktoren und dergleichen auf, bei dem auf engstem Raum acht mal drei Anschlüsse - also acht mal drei Ebenen - ausgebildet sind. Es handelt sich bei diesem Stecker 20 um einen sogenannten BLI/O-Stecker. Der Stecker 20 ist über eine Elektronikleiterplatte 21 mit dem internen Busleiter 3' verbunden. Auch dieses selbstständig für sich erfinderische, da besonders kompakt viele Anschlüsse auf engem Raum realisierende Modul ist über Adaptermodulen B mit Modulen der Bauart A kombinierbar.

### Bezugszeichen

- Module: A, B, C
- Gateway: G
- Klemmenträger: 2
- interner Busleiterabschnitt: 3
- Buchsenleiste: 4
- Steckerleiste: 5
- Druckkontakte: 6
- Ausnehmung: 7
- Stiftkontakte: 8
- Leiterplatte: 9
- Leiterplatte: 10
- Leiterplatte: 11
- Stifte: 12
- Leiterplatte: 13
- Kontaktbereiche: 14
- Stifte: 15
- Zwischenklemmenträger: 16
- Leiterplatte: 17
- Stecker: 20
- Leiterplatte: 21

## Patentansprüche

1. Modulreihung aus Modulen (A, C), insbesondere der Automatisierungstechnik, auf einer Tragschiene,
a) wobei die Modulreihung wenigstens ein Modul (A) erster Bauart mit einem ersten Klemmenträger (2) und ein zum ersten Modul nicht kompatibles Modul verschiedener zweiter Bauart mit einem relativ zum ersten Klemmenträger größeren Klemmenträger (3) aufweist,
b) mit axialseitigen, zur Querverbindung vorgesehenen Kontakte gleicher oder unterschiedlicher Bauart, die mit einem gegebenen Höhenversatz, einem Seitenversatz und/oder unterschiedlichem Raster an den beiden Klemmenträgern der beiden Module erster und zweiter Bauart angeordnet sind,
c) wobei eine Kopplung der Module (A, C) verschiedener Bauart mit Hilfe eines Adapatermoduls (B) erfolgt, welches zwischen den zwei Modulen (A, C) verschiedener Bauart (B) angeordnet ist und elektrische Kontakte an seinen beiden Axialseiten aufweist,
d) wobei die Kontakte des Adaptermoduls (B) auf der einen Axialseite kompatibel zu den Kontakten des Moduls (A) der ersten Bauart und die Kontakte der anderen Axialseite kompatibel zu den Kontakten des Moduls (C)der zweiten Bauart ausgelegt sind,
e) wobei die Kontakte der beiden Axialseiten des Adaptermodules elektrisch leitend oder lichtleitend miteinander verbunden sind, so dass der gegebene Höhenversatz, der Seitenversatz und/oder das unterschiedliche Raster der Kontakte am Klemmenträger ausgeglichen wird.

2. Modulreihung nach Anspruch 1, **dadurch gekennzeichnet, daß** die Kontakte internen Busleiterabschnitten (3, 3', 3") der Module zugeordnet sind, welche beim Aneinanderreihen der Module einen sich über die Modulreihung erstreckenden internen Busleiter ausbilden.

3. Modulreihung nach Anspruch 2, **dadurch gekennzeichnet, daß** die internen Busleiterabschnitte (3, 3', 3") in Klemmenträgern (2, 2', 2") angeordnet sind.

4. Modulreihung nach einem der vorstehenden Ansprüche, **dadurch gekennzeichnet, daß** das Adaptermodul eine elektrisch leitende Koppeleinrichtung aufweist, die elektrische Kontakte eines ersten Typs und/oder eines ersten Rasters und/oder einer ersten Anordnung mit elektrischen Kontakten eines zweiten Typs und/oder eines zweiten Rasters und/oder einer zweiten Anordnung verbindet.

5. Modulreihung nach einem der vorstehenden Ansprüche, **dadurch gekennzeichnet, daß** das Adaptermodul ferner verschiedene mechanische Koppelelemente für korrespondierende Koppelelemente der Module verschiedener Bauart aufweist.

6. Modulreihung nach einem der vorstehenden Ansprüche, **dadurch gekennzeichnet, daß** das Adaptermodul auf seinen beiden voneinander abgewandten Axialseiten Kontakte aufweist, welche mit den Kontakten der Module des ersten und des zweiten Typs kompatibel sind.

7. Modulreihung nach einem der vorstehenden Ansprüche, **dadurch gekennzeichnet, dass** die Kontakte auf den beiden Axialseiten des Koppelmoduls über wenigstens eine oder mehrere Leiterplatte(n) miteinander verbunden sind.

8. Modulreihung nach einem der vorstehenden Ansprüche, **dadurch gekennzeichnet, dass** die Kontakte auf den beiden Axialseiten des Koppelmoduls über wenigstens ein Kabel, insbesondere eine Flachbandverbindung und/oder Folienleiter miteinander verbunden sind.

9. Modulreihung nach einem der vorstehenden Ansprüche, **dadurch gekennzeichnet, daß** das Adaptermodul auf die Tragschiene und/oder an eines der Module aufrastbar ist.

10. Modulreihung nach einem der vorstehenden Ansprüche, **dadurch gekennzeichnet, daß** das Adaptermodul ein Klemmenträger aufweist, dessen Geometrie der Geometrie von einem der Module angepasst ist.

11. Modulreihung nach einem der vorstehenden Ansprüche, **dadurch gekennzeichnet, daß** die Kontakte des Adaptermoduls als Buchsen- und/ oder Stiftleiste oder als gebogene Stifte oder als Druckkontakte oder als Leiterplattenkontaktbereiche oder als leitende Leiterplattenränder ausgebildet sind.

12. Modulreihung nach einem der vorstehenden Ansprüche, **dadurch gekennzeichnet, dass** die Module der Automatisierungstechnik oder Reihenklemmen sind, welche Querverbinder an ihren Axialseiten aufweisen, die zur Querverbindung von Potentialen über mehrere aneinander gereihte Reihenklemmen hinweg dienen.

13. Modulreihung nach einem der vorstehenden Ansprüche, **dadurch gekennzeichnet, daß** der interne Busleiterabschnitt (3") des Adaptermodules wenigstens eine Leiterplatte aufweist, an welcher die Kontakte angeordnet und/oder ausgebildet sind.

14. Modulreihung nach einem der vorstehenden Ansprüche, **dadurch gekennzeichnet, daß** die Leiterplatte senkrecht zur Tragschiene oder parallel zur Tragschiene im Adaptermodul ausgerichtet ist.

15. Modulreihung nach einem der vorstehenden Ansprüche, **dadurch gekennzeichnet, daß** die Leiterplatte Kontaktränder oder einen Leiterplattenkontaktbereich zur direkten Kontaktierung der Kontakte benachbarter Module aufweist.

16. Modulreihung nach einem der vorstehenden Ansprüche, **dadurch gekennzeichnet, daß** der interne Busleiterabschnitt (3") des Koppelmoduls (B) eine Stift- und/oder eine Buchsenleiste (4) aufweist.

17. Modulreihung nach einem der vorstehenden Ansprüche, **dadurch gekennzeichnet, daß** der interne Busleiterabschnitt (3") des Koppelmoduls (B) Stiftkontakte aufweist.

18. Modulreihung nach einem der vorstehenden Ansprüche, **dadurch gekennzeichnet, dass** eine Buchsen- oder Stiftleiste direkt auf der Leiterplatte des Adaptermoduls angeordnet ist.

19. Modulreihung nach einem der vorstehenden Ansprüche, **dadurch gekennzeichnet, dass** eine Buchsen- oder Stiftleiste durch eine aufrecht stehende Leiterplatte hindurch geführt und an der gegenüberliegenden Seite der Leiterplatte oberflächenverlötet ist.

20. Modulreihung nach einem der vorstehenden Ansprüche, **dadurch gekennzeichnet, daß** das Adaptermodul als Zwischenklemmenträger (16) ausgebildet, ist, welches direkt zwischen die miteinander zu verbindenden Module A und C gesetzt ist.

## Claims

1. Module series of modules (A, C), in particular for automation technology, on a support rail,
a) such that the module series comprises at least one module (A) having a first structure, with a first terminal support (2), and a module having a second, different structure not compatible with the first module, with a terminal support (3) larger compared with the first terminal support,
b) with axial contacts of the same or different structure provided for cross-connection, which are arranged on the two terminal supports of the modules having the first and second structures with a given height offset, a lateral offset and/or in a different grid pattern,
c) such that coupling of the modules (A, C) having different structures takes place with the aid of an adaptor module (B) arranged between the two modules (A, C) with different structure, the module (B) having electric contacts on both its axial sides,
d) such that the contacts of the adaptor module (B) on one axial side are positioned compatibly with the contacts of the module (A) having the first structure and the contacts on its other side are positioned compatibly with the contacts of the module (C) having the second structure,
e) such that the contacts on the two axial sides of the adaptor module are connected to one another electrically or by light conductors, so that the given height offset, lateral offset and/or the different grid pattern of the contacts on the terminal supports is compensated.

2. Module series according to Claim 1, **characterised in that** the contacts are associated with internal bus bar sections (3, 3' , 3" ) of the modules, which form an internal bus bar that extends through the module series when the modules are connected in sequence.

3. Module series according to Claim 2, **characterised in that** the internal bus bar sections (3, 3' , 3" ) are arranged in terminal supports (2, 2' , 2" ).

4. Module series according to any of the preceding claims, **characterised in that** the adaptor module comprises an electrically conducting coupling device, which connects electric contacts of a first type and/or in a first grid pattern and/or a first arrangement with electric contacts of a second type and/or in a second grid pattern and/or a second arrangement.

5. Module series according to any of the preceding claims, **characterised in that** the adaptor module also comprises various mechanical coupling elements for corresponding coupling elements of the modules with different structures.

6. Module series according to any of the preceding claims, **characterised in that** the adaptor module has contacts which are compatible with the contacts of the modules of the first and second type.

7. Module series according to any of the preceding claims, **characterised in that** the contacts on the two axial sides of the coupling module are connected to one another by means of at least one or more printed circuit board(s).

8. Module series according to any of the preceding claims, **characterised in that** the contacts on the two axial sides of the coupling module are connected to one another by means of at least one cable, in particular a flat-strip connector and/or foil connector.

9. Module series according to any of the preceding claims, **characterised in that** the adaptor module can be locked onto the support rail and/or on one of the modules.

10. Module series according to any of the preceding claims, **characterised in that** the adaptor module has a terminal support whose geometry is adapted to the geometry of one of the modules.

11. Module series according to any of the preceding claims, **characterised in that** the contacts of the adaptor module are formed as socket and/or pin strips or as bent pins, or as pressure contacts, or as printed circuit board contact areas, or as conductive printed circuit board edges.

12. Module series according to any of the preceding claims, **characterised in that** the modules are automation technology or line-up terminals, which have cross-connectors on their axial sides that serve for the cross-connection of potentials via several line-up terminals sequenced with one another.

13. Module series according to any of the preceding claims, **characterised in that** the internal bus bar section (3") of the adaptor module comprises at least one printed circuit board on which the contacts are arranged and/or formed.

14. Module series according to any of the preceding claims, **characterised in that** the printed circuit board is directed perpendicular or parallel to the support rail in the adaptor module.

15. Module series according to any of the preceding claims, **characterised in that** the printed circuit board has contact edges or a printed circuit board contact area for direct connection to the contacts of adjacent modules.

16. Module series according to any of the preceding claims, **characterised in that** the internal bus bar section (3") of the coupling module (B) comprises a pin and/or a socket strip (4).

17. Module series according to any of the preceding claims, **characterised in that** the internal bus bar section (3") of the coupling module (B) comprises pin contacts.

18. Module series according to any of the preceding claims, **characterised in that** a socket or pin strip is arranged directly on the printed circuit board of the adaptor module.

19. Module series according to any of the preceding claims, **characterised in that** a socket or pin strip passes through a printed circuit board standing upright and is soldered to the surface on the opposite side of the printed circuit board.

20. Module series according to any of the preceding claims, **characterised in that** the adaptor module is formed as an intermediate terminal support (16), which is positioned directly between the modules A and C to be connected to one another.

## Revendications

1. Série de modules constituée de modules (A, C), en particulier appartenant à la technique d'automatisation, sur un rail porteur, dans laquelle :
a) la série de modules comporte au moins un module (A) de premier type de construction avec un premier porte-bornes (2) et un module non compatible avec le premier module d'un deuxième type de construction différent avec un porte-bornes (3) plus grand que le premier porte-bornes,
b) des contacts côté axial sont prévus pour la liaison transversale, de type de construction identique ou différent, qui sont disposés avec un décalage en hauteur défini, un décalage latéral et/ou une trame différente, sur les deux porte-bornes des deux modules du premier et du deuxième type de construction,
c) un couplage des modules (A, C) de différents types de construction est effectué à l'aide d'un module d'adaptation (B) qui est disposé entre les deux modules (A, C) de type de construction (B) différent et comporte des contacts électriques sur ses deux côtés axiaux,
d) les contacts du module d'adaptation (B) sur un côté axial sont conçus compatibles avec les contacts du module (A) du premier type de construction et les contacts du deuxième côté axial sont conçus compatibles avec les contacts du module (C) du deuxième type de construction,
e) les contacts des deux côtés axiaux du module d'adaptation sont reliés entre eux de manière électriquement conductrice
ou optiquement conductrice, ce qui fait que le décalage en hauteur défini, le décalage latéral et/ou la trame différente des contacts sur le porte-bornes est compensé.

2. Série de modules selon la revendication 1, **caractérisée en ce que** les contacts sont associés à des tronçons de conducteur de bus (3, 3', 3") internes des modules, lesquels forment un conducteur de bus interne s'étendant sur la série de modules, lorsque les modules sont juxtaposés.

3. Série de modules selon la revendication 2, **caractérisée en ce que** les tronçons de conducteurs de bus internes (3, 3', 3") sont disposés dans des porte-bornes (2, 2', 2").

4. Série de modules selon l'une des revendications précédentes, **caractérisée en ce que** le module d'adaptation comporte un dispositif de couplage électriquement conducteur qui relie des contacts électriques d'un premier type et/ou d'une première trame et/ou d'une première disposition à des contacts électriques d'un deuxième type et/ou d'une deuxième trame et/ou d'une deuxième disposition,

5. Série de modules selon l'une des revendications précédentes, **caractérisée en ce que** le module d'adaptation comporte en outre différents éléments de couplage mécaniques pour des éléments de couplage correspondants des modules de différents types de construction.

6. Série de modules selon l'une des revendications précédentes, **caractérisée en ce que** le module d'adaptation comporte, sur ses deux côtés axiaux tournés à l'opposé l'un de l'autre, des contacts qui sont compatibles avec les contacts des modules du premier et du deuxième type.

7. Série de modules selon l'une des revendications précédentes, **caractérisée en ce que** les contacts sur les deux côtés axiaux du module de couplage sont reliés entre eux par au moins une ou plusieurs plaquettes à circuits imprimés.

8. Série de modules selon l'une des revendications précédentes, **caractérisée en ce que** les contacts sur les deux côtés axiaux du module de couplage sont reliés entre eux par au moins un câble, en particulier une liaison à ruban plat et/ou des conducteurs en feuille.

9. Série de modules selon l'une des revendications précédentes, **caractérisée en ce que** le module d'adaptation peut être clipsé sur le rail porteur et/ou sur l'un des modules.

10. Série de modules selon l'une des revendications précédentes, **caractérisée en ce que** le module d'adaptation comporte un porte-bornes, dont la géométrie est adaptée à la géométrie de l'un des modules.

11. Série de modules selon l'une des revendications précédentes, **caractérisée en ce que** les contacts du module d'adaptation sont réalisés en tant que barrettes de douilles et/ou barrettes de broches ou en tant que broches recourbées ou en tant que contacts de pression ou en tant que zones de contact de plaquettes à circuits imprimés ou en tant que bords conducteurs de plaquettes à circuits imprimés.

12. Série de modules selon l'une des revendications précédentes, **caractérisée en ce que** les modules sont des modules appartenant à la technique d'automatisation ou des barrettes de bornes qui comportent des organes de liaison transversale sur leurs côtés axiaux, lesquels servent à la liaison transversale de potentiels par plusieurs barrettes de bornes alignées les unes contre les autres.

13. Série de modules selon l'une des revendications précédentes, **caractérisée en ce que** le tronçon de conducteur de bus Interne (3") du module d'adaptation comporte eu moins une plaquette à circuits imprimés sur laquelle sont disposés et/ou réalisés les contacts.

14. Série de modules selon l'une des revendications précédentes, **caractérisée en ce que** la plaquette à circuits imprimés est orientée perpendiculairement au rall porteur ou parallèlement au rail porteur dans le module d'adaptation.

15. Série de modules selon l'une des revendications précédentes, **caractérisée en ce que** la plaquette à circuits imprimés comporte des bords formant contact ou une zone de contact de plaquettes à circuits imprimés pour la mise en contact directe des contacts de modules voisins.

16. Série de modules selon l'une des revendications précédentes, **caractérisée en ce que** le tronçon de conducteur de bus interne (3") du module de couplage (B) comporte une barrette de broches et/ou une barrette de douilles (4).

17. Série de modules selon l'une des revendications précédentes, **caractérisée en ce que** le tronçon de conducteur de bus Interne (3") du module de couplage (B) comporte des contacts à broches.

18. Série de modules selon l'une des revendications précédentes, **caractérisée en ce qu'**une barrette de douilles ou barrette de broches est disposée directement sur la plaquette à circuits imprimés du module d'adaptation.

19. Série de modules selon l'une des revendications précédentes, **caractérisée en ce qu'**une barrette de douilles ou barrette de broches est dirigée à travers une plaquette à circuits imprimés se tenant verticalement et est brasée en surface sur le côté opposé de la plaquette à circuits imprimés.

20. Série de modules selon l'une des revendications précédentes, **caractérisée en ce que** le module d'adaptation est réalisé en tant que porte-bornes intermédiaire (16), qui est directement placé entre les modules (A) et (C) à relier entre eux.
